# DEMANDE DE BREVET EUROPEEN

(11) **EP 2 355 152 A1**
(43) Date de publication de la demande: **10.08.2011**
(21) Numéro de dépôt: 10197148.9
(22) Date de dépôt: 28.12.2010
(51) Int. Cl.: H01L 27/02

(54) **Circuit intégré muni d'une protection contre des décharges électrostatiques**

(30) Priorité: 08.02.2010 FR 1050860
(71) Demandeur: STMicroelectronics (Rousset) SAS, 13790 Rousset (FR)
(72) Inventeur: Tailliet, François, 13710, FUVEAU (FR)
(74) Mandataire: de Beaumont, Michel

(57) **Abrégé**

L'invention concerne un circuit intégré protégé contre des décharges électrostatiques, dont des plots de sortie (3) sont couplés à des étages d'amplification, chaque étage comprenant, entre des premier (V_{DD}) et second (V_{SS}) rails d'alimentation, un transistor MOS de puissance à canal P (31) en série avec un transistor MOS de puissance à canal N (33), ce circuit intégré comprenant en outre des moyens de protection pour fermer simultanément les deux transistors lorsqu'une surtension positive survient entre les premier et second rails d'alimentation.

## Description

### Domaine de l'invention

La présente invention concerne la protection des circuits intégrés contre des décharges électrostatiques.

### Exposé de l'art antérieur

Un circuit intégré comprend des plots métalliques destinés à assurer des connexions vers l'extérieur. Certains des plots sont adaptés à recevoir des potentiels d'alimentation. Les autres plots sont adaptés à recevoir et/ou à fournir des signaux d'entrée-sortie. Des rails d'alimentation, reliés aux plots d'alimentation, sont généralement prévus tout autour du circuit pour alimenter ses différents composants. Généralement, une couche isolante recouvre le circuit, ne laissant accessible que les plots métalliques.

Un tel circuit reçoit et/ou fournit généralement des signaux à faible niveau de tension (par exemple 1 à 5 V) et à faible intensité de courant (par exemple 1 µA à 10 mA), et est susceptible d'être endommagé lorsque des surtensions ou des surintensités surviennent entre des plots du circuit.

On prévoit donc d'associer à chaque plot une structure de protection. La structure de protection doit pouvoir évacuer rapidement des courants importants, susceptibles d'apparaître lorsqu'une décharge électrostatique survient sur un plot d'entrée-sortie (on parlera simplement de "plot") ou sur un plot relié à un rail d'alimentation (on parlera simplement de "rail").

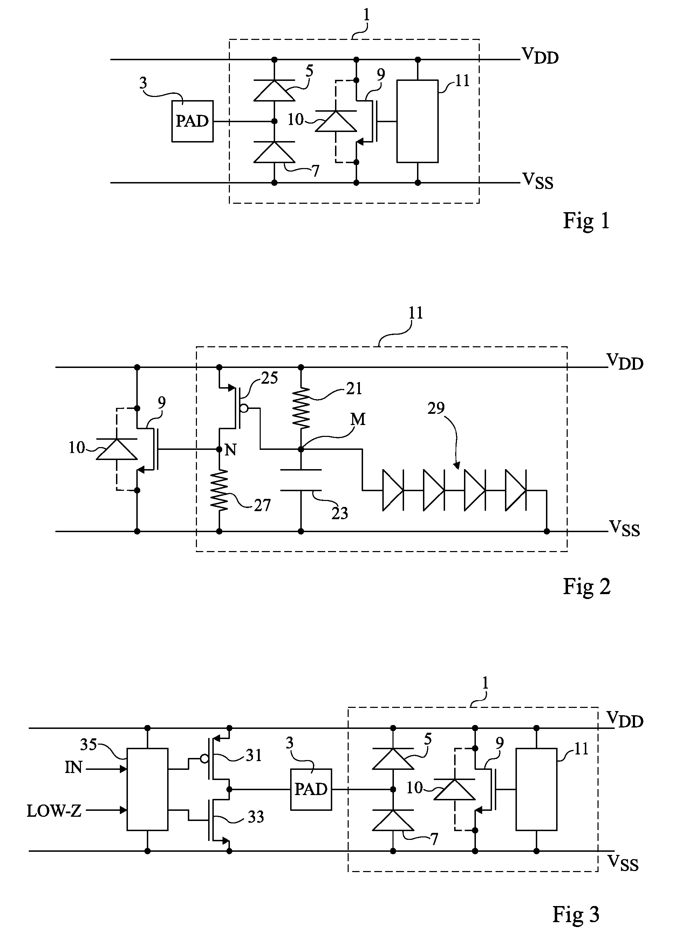

La figure 1 représente un exemple d'une structure de protection 1 associée à un plot d'entrée-sortie 3 d'un circuit intégré. Une diode 5 est connectée en direct entre le plot 3 et un rail d'alimentation haute V_{DD}. Une diode 7 est connectée en inverse entre le plot 3 et un rail d'alimentation basse V_{SS}. Un transistor MOS 9, utilisé comme interrupteur, est connecté entre les rails V_{DD} et V_{SS} d'alimentation haute et basse. Un circuit 11 de détection de surtension, connecté parallèlement au transistor MOS 9, fournit un signal de déclenchement à ce transistor. Le transistor MOS 9 comprend une diode parasite 10 connectée en direct entre le rail V_{SS} et le rail V_{DD}.

En fonctionnement normal, lorsque la puce est alimentée, les signaux sur le plot 3 et les rails V_{DD} et V_{SS} sont tels que les diodes 5 et 7 ne laissent pas passer de courant et le circuit de détection 11 rend le transistor MOS 9 non passant.

En cas de surtension positive entre les rails V_{DD} et V_{SS}, le circuit 11 rend le transistor 9 passant, ce qui permet l'évacuation de la surtension.

En cas de surtension négative entre les rails V_{DD} et V_{SS}, la diode parasite 10 du transistor 9 devient passante et la surtension est évacuée.

En cas de surtension positive entre le plot 3 et le rail d'alimentation haute V_{DD}, la diode 5 devient passante et la surtension est évacuée.

En cas de surtension négative entre le plot 3 et le rail V_{DD}, le circuit 11 rend le transistor 9 passant, et la surtension est évacuée par le transistor 9 et la diode 7.

En cas de surtension positive entre le plot 3 et le rail V_{SS}, la diode 5 devient passante et la surtension positive est reportée sur le rail V_{DD}, ce qui correspond au cas traité ci-dessus d'une surtension positive les rails V_{DD} et V_{SS}.

En cas de surtension négative entre le plot 3 et le rail V_{SS}, la diode 7 devient passante et la surtension est évacuée.

En cas de surtension positive ou négative entre deux plots 3 d'entrée-sortie, les diodes 5 ou 7 associées aux plots concernés deviennent passantes, et la surtension est reportée sur les rails d'alimentation haute V_{DD} et basse V_{SS}. Cela correspond à l'un des cas de surtension traités ci-dessus.

La figure 2 reprend en partie le schéma de la figure 1, et représente de façon plus détaillée un exemple de réalisation possible d'un circuit 11 de détection de surtension positive entre les rails V_{DD} et V_{SS}, et de commande du transistor 9 de protection. Un détecteur de fronts, constitué d'une résistance 21 en série avec une capacité 23, est connecté entre les rails d'alimentation V_{DD} et V_{SS}. Le noeud M entre la résistance 21 et la capacité 23 est connecté à la grille d'un transistor MOS à canal P 25, dont la source est connectée au rail V_{DD} et dont le drain est relié au rail V_{SS} par l'intermédiaire d'une résistance 27. Le noeud N entre le drain du transistor 25 et la résistance 27 est connecté à la grille du transistor 9. Un ensemble 29 de diodes en série est connecté, en direct, entre le noeud M et le rail V_{SS}. Dans cet exemple, l'ensemble 29 comprend quatre diodes en série.

En fonctionnement normal, lorsque le circuit est alimenté, le noeud M est à un état haut. Le transistor MOS à canal P 25 ne laisse donc pas passer de courant. Ainsi, le noeud N de grille du transistor 9 est à un état bas, et le transistor de protection 9 est maintenu ouvert. Lorsque la différence de potentiel entre les rails V_{DD} et V_{SS} augmente, le potentiel du noeud M augmente également. Lorsque le potentiel du noeud M atteint un certain seuil, l'ensemble de diodes 29 devient passant. Dans cet exemple, si chaque diode a une tension de seuil de 0,6 V, l'ensemble 29 devient passant lorsque le potentiel du noeud M dépasse 2,4 V. Il s'ensuit une chute du potentiel du noeud M, provoquant la fermeture du transistor MOS à canal P 25. Ainsi, le noeud N de grille du transistor 9 de protection passe à un état haut, c'est-à-dire sensiblement au même potentiel positif que le rail V_{DD}. Le transistor 9 devient donc passant, et la surtension est évacuée.

Lorsque le circuit intégré n'est pas alimenté, le noeud M est à un état bas. Le transistor 25 n'étant pas alimenté, le noeud N de drain de ce transistor est à un état indéterminé. Si une surtension positive brutale (montée de potentiel rapide) survient entre les rails V_{DD} et V_{SS}, le noeud M reste à un état bas. Le transistor 25 devient donc passant et le noeud N passe à un état haut. Ainsi, le transistor 9 de protection est rendu passant, et la surtension est évacuée.

Un inconvénient de la structure de protection des figures 1 et 2 réside dans le fait que, pour pouvoir évacuer les courants induits par des décharges électrostatiques, les diodes 5 et 7 et le transistor 9 doivent avoir une surface importante (par exemple, un périmètre de jonction de 200 µm par diode et une largeur de canal de plusieurs dizaines de millimètres pour le transistor). Il en résulte qu'une surface importante de silicium est exclusivement dédiée à la protection contre les décharges électrostatiques, au détriment des autres composants du circuit. En outre, du fait de sa grande taille, le transistor MOS 9, à l'état bloqué, est traversé par des courants de fuite significatifs, ce qui augmente la consommation du circuit et la capacité parasite entre les rails V_{DD} et V_{SS}.

### Résumé

Un objet de la présente invention est de proposer un circuit intégré muni d'une protection contre des décharges électrostatiques, cette protection n'augmentant pas ou peu la surface de silicium occupée par le même circuit non protégé.

Un objet d'un mode de réalisation de la présente invention est de proposer une telle protection ne perturbant pas le bon fonctionnement du circuit dans les conditions normales d'utilisation.

Un objet d'un mode de réalisation de la présente invention est de proposer une telle protection facile à réaliser.

De façon générale, un mode de réalisation de la présente invention prévoit d'utiliser, en cas de surtension, des transistors MOS de puissance, existant dans les étages d'amplification de sortie du circuit intégré, comme chemin d'évacuation de la surtension.

Ainsi, un mode de réalisation de la présente invention prévoit un circuit intégré protégé contre des décharges électrostatiques, dont des plots de sortie sont couplés à des étages d'amplification, chaque étage comprenant, entre des premier et second rails d'alimentation, un transistor MOS de puissance à canal P en série avec un transistor MOS de puissance à canal N, ce circuit intégré comprenant en outre des moyens de protection pour fermer simultanément les deux transistors lorsqu'une surtension positive survient entre les premier et second rails d'alimentation.

Selon un autre mode de réalisation de la présente invention, dans chaque étage d'amplification, les sources des transistors à canal P et N sont respectivement reliées aux premier et second rails d'alimentation, et les drains des transistors sont reliés au plot de sortie.

Selon un autre mode de réalisation de la présente invention, le circuit intégré comprend un circuit de commande de chaque étage d'amplification pour commander, en fonctionnement normal, l'ouverture et la fermeture des transistors, ce circuit de commande comprenant au moins une sortie reliée aux grilles des transistors à canal P et N, et les moyens de protection comprennent : des première et seconde résistances respectivement connectées entre la sortie du circuit de commande et les grilles respectives des transistors à canal P et N ; et un circuit de détection et de déclenchement comportant des première et seconde sorties connectées respectivement aux grilles des transistors à canal P et N, adapté à fermer simultanément les deux transistors lorsqu'une surtension positive survient entre les premier et second rails d'alimentation.

Selon un autre mode de réalisation de la présente invention, le circuit de commande de l'étage d'amplification est relié aux premier et second rails d'alimentation par l'intermédiaire de transistors MOS à canal P et N, dont les grilles respectives sont reliées à des détecteurs de fronts adaptés à commander l'ouverture de ces transistors lorsqu'une surtension positive survient entre les premier et second rails d'alimentation.

Selon un autre mode de réalisation de la présente invention, le circuit de détection et de déclenchement comprend : une première diode Zener connectée en direct entre sa seconde sortie et le premier rail ; et une seconde diode Zener connectée en direct en le second rail et sa première sortie.

Selon un autre mode de réalisation de la présente invention, le circuit de détection et de déclenchement comprend : un premier détecteur de fronts comprenant une résistance en série avec une capacité, connecté entre les premier et second rails ; un second détecteur de fronts comprenant une résistance en série avec une capacité, connecté entre les second et premier rails ; un transistor MOS à canal P dont la source et le drain sont respectivement connectés au premier rail et à la première sortie, et dont la grille est connectée entre la résistance et la capacité du premier détecteur de fronts ; un transistor MOS à canal N dont la source et le drain sont respectivement connectés au second rail et à la seconde sortie, et dont la grille est connectée entre la résistance et la capacité du second détecteur de fronts ; et des première et seconde diodes Zener respectivement connectées en direct entre le second rail (V_{SS}) et la grille du transistor à canal P, et entre la grille du transistor à canal N et le premier rail.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, décrite précédemment, représente un exemple de structure de protection contre les surtensions associée à un plot d'un circuit intégré ;
la figure 2, précédemment décrite, reprend en partie le schéma de la figure 1, et représente de façon plus détaillée un exemple de réalisation possible d'un détecteur de surtension positive entre les rails d'alimentation du circuit intégré ;
la figure 3 reprend le schéma de la figure 1, et représente en outre un étage d'amplification, associé à un plot de sortie d'un circuit intégré ;
la figure 4 reprend en partie le schéma de la figure 3, et représente de façon plus détaillée un exemple de réalisation possible d'un étage d'amplification de sortie d'un circuit intégré ;
la figure 5 représente une structure de protection contre des surtensions utilisant, comme élément de protection, les transistors d'un étage d'amplification de sortie d'un circuit intégré ;
la figure 6 représente de façon plus détaillée un exemple de réalisation de la structure de protection de la figure 5 ;
la figure 7 représente un exemple de réalisation d'un circuit de détection et de déclenchement associé à une structure de protection du type décrit en relation avec la figure 6 ;
la figure 8 représente un autre exemple de réalisation d'un circuit de détection et de déclenchement associé à une structure de protection du type décrit en relation avec la figure 6 ;
la figure 9 représente une variante de réalisation d'une structure de protection du type décrit en relation avec les figures 5 et 6 ;
la figure 10 représente un exemple de réalisation d'un circuit de détection et de déclenchement associé à une structure de protection du type décrit en relation avec la figure 9 ; et
la figure 11 représente un autre exemple de réalisation d'un circuit de détection et de déclenchement associé à une structure de protection du type décrit en relation avec la figure 9.

### Description détaillée

Par souci de clarté, de mêmes éléments ont été désignés par de mêmes références aux différentes figures.

Dans un circuit intégré, à chaque plot de sortie est associé un étage d'amplification de sortie, pour adapter la puissance (faible) des signaux internes du circuit, à un niveau (plus élevé) exploitable à l'extérieur du circuit.

La figure 3 reprend le schéma de la figure 1 d'une structure de protection associée à un plot 3 d'un circuit intégré, dans le cas où ce plot est un plot de sortie. En ce cas, un étage d'amplification de sortie est associé au plot 3.

L'étage d'amplification de sortie comprend un transistor MOS à canal P de puissance 31, en série avec un transistor MOS à canal N de puissance 33. Les sources des transistors 31 et 33 sont connectées respectivement aux rails V_{DD} et V_{SS} d'alimentation haute et basse. Les drains des transistors 31 et 33 sont interconnectés en un noeud relié au plot de sortie 3 du circuit. Un circuit 35 de commande de l'étage d'amplification est prévu pour commander les grilles des transistors 31 et 33. Dans cet exemple, le circuit 35 comprend deux entrées IN et LOW-Z, et deux sorties, respectivement connectées aux grilles des transistors 31 et 33, pour commander le passage du courant dans l'un ou l'autre des transistors 31 et 33 en fonction de l'état des entrées IN et LOW-Z. Le signal IN correspond au signal qui doit être amplifié par l'étage d'amplification. Le signal LOW-Z commande la mise à haute impédance du plot de sortie, c'est-à-dire l'ouverture simultanée des transistors 31 et 33. Pour son alimentation, le circuit 35 est relié aux rails V_{DD} et V_{SS}.

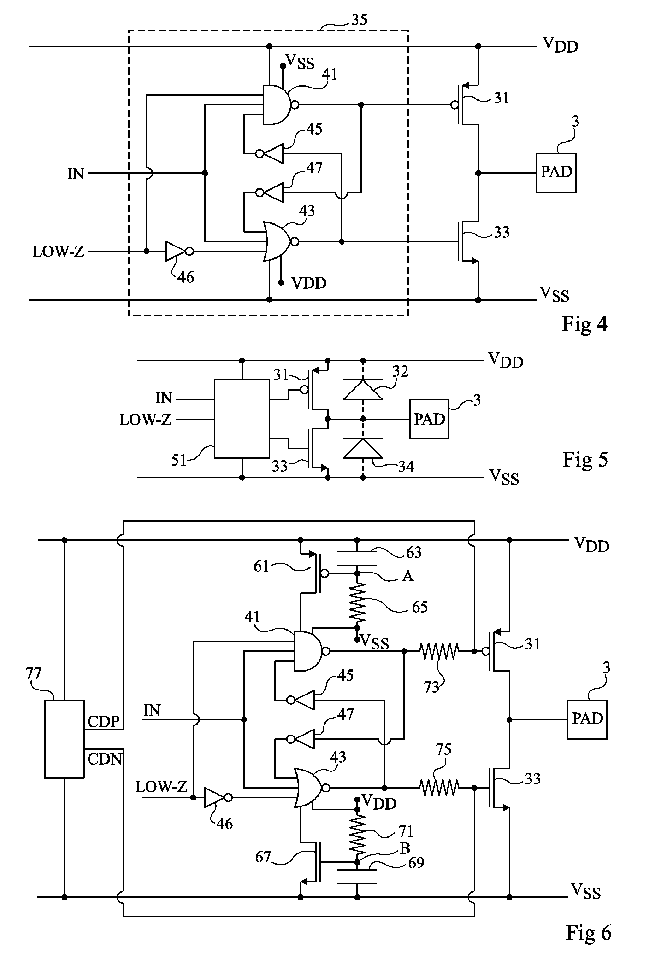

La figure 4 représente de façon plus détaillée un exemple de réalisation possible du circuit 35 de commande de l'étage d'amplification de sortie 31, 33. Le circuit 35 comprend une porte NON ET 41 à trois entrées et une porte NON OU 43 à trois entrées. Les sorties des portes NON ET 41 et NON OU 43 sont respectivement connectées aux grilles des transistors 31 et 33. La porte NON ET 41 reçoit le signal IN, le signal LOW-Z, et le signal de sortie de la porte NON OU 43 inversé par un inverseur 45. La porte NON OU 43 reçoit le signal IN, le signal LOW-Z inversé par un inverseur 46, et le signal de sortie de la porte NON ET 41 inversé par un inverseur 47. Pour leur alimentation, les portes logiques 41, 43, 45, 46 et 47 sont reliées aux rails d'alimentation V_{DD} et V_{SS}.

Lorsque le signal LOW-Z est à un état bas, pour mettre à haute impédance le plot de sortie 3, les noeuds de grille des transistors 31 et 33 sont respectivement à des états haut et bas. Ainsi, les transistors 31 et 33 sont tous deux ouverts, et le plot 3 est à haute impédance.

Lorsque le signal LOW-Z est à un état haut, l'état des noeuds de grille des transistors 31 et 33 est déterminé par le signal IN.

Le circuit de commande 35 est prévu pour commander la fermeture de l'un ou l'autre des transistors 31 et 33 (amplification du signal d'entrée IN), ou l'ouverture simultanée des transistors 31 et 33 (mise à haute impédance du plot de sortie), mais jamais la fermeture simultanée des deux transistors, ce qui court-circuiterait l'alimentation du circuit intégré. Le retour du signal de sortie de la porte NON ET 41 vers l'entrée de la porte NON OU 43, via l'inverseur 47, et le retour du signal de sortie de la porte NON OU 43 vers l'entrée de la porte NON ET 41, via l'inverseur 45, permettent de garantir que les transistors de puissance 31 et 33 ne soient pas simultanément fermés, même pendant un court instant, par exemple lors des commutations du signal IN.

On propose ici d'utiliser les transistors MOS de puissance des étages d'amplification de sortie d'un circuit intégré, comme chemin d'évacuation des décharges électrostatiques. On propose notamment, en cas de surtension positive entre les rails d'alimentation V_{DD} et V_{SS}, de fermer simultanément les transistors 31 et 33 pour permettre l'évacuation de la surtension.

La figure 5 représente de façon schématique un mode de réalisation d'une structure de protection associée à un plot de sortie d'un circuit intégré, utilisant les transistors de l'étage d'amplification de sortie associé au plot, comme éléments de protection contre des décharges électrostatiques.

Un circuit de commande 51, connecté entre les rails d'alimentation V_{DD} et V_{SS}, est prévu pour commander les grilles des transistors 31 et 33 de l'étage d'amplification de sortie associé au plot 3. On a représenté sur la figure les diodes parasites 32 et 34 des transistors 31 et 33. Les diodes 32 et 34 sont connectées respectivement en direct entre le plot 3 et le rail V_{DD} et en inverse entre le plot 3 et le rail V_{SS}. Comme le circuit de commande 35 décrit en relation avec les figures 3 et 4, le circuit 51 comprend deux entrées IN et LOW-Z, et deux sorties, respectivement connectées aux grilles des transistors 31 et 33, pour commander le passage du courant dans l'un ou l'autre des transistors en fonction de l'état des entrées IN et LOW-Z. Le circuit 51 comprend en outre des moyens de protection pour commander la fermeture simultanée des transistors 31 et 33 en cas de surtension positive entre les rails V_{DD} et V_{SS}.

En cas de surtension positive entre les rails V_{DD} et V_{SS}, le circuit 51 commande la fermeture des transistors 31 et 33, ce qui permet l'évacuation de la surtension.

En cas de surtension négative entre les rails V_{DD} et V_{SS}, les diodes 34 et 32 deviennent passantes, et la surtension est évacuée.

En cas de surtension positive entre le plot 3 et le rail d'alimentation haute V_{DD}, la diode 32 devient passante et la surtension est évacuée.

En cas de surtension négative entre le plot 3 et le rail V_{DD}, le circuit 51 commande la fermeture des transistors 31 et 33, et la surtension est évacuée par le transistor 31.

En cas de surtension positive entre le plot 3 et le rail V_{SS}, la diode 32 devient passante et la surtension positive est reportée sur le rail V_{DD}. Le circuit 51 commande la fermeture des transistors 31 et 33, et la surtension est évacuée par le transistor 33.

En cas de surtension négative entre le plot 3 et le rail V_{SS}, la diode 34 devient passante et la surtension est évacuée.

En cas de surtension positive ou négative entre deux plots 3 d'entrée-sortie, la diode 32 associée au plot le plus positif devient passante. Le circuit 51 commande alors la fermeture des transistors 31 et 33, et la surtension est évacuée via le transistor 33 associé au plot le plus positif et via la diode 34 associée au plot le moins positif, et, parallèlement, via la diode 32 associée au plot le plus positif et via le transistor 31 associé au plot le moins positif.

Ainsi, les transistors 31 et 33 permettent d'évacuer tout type de surtension susceptible de survenir entre deux plots (de sortie) ou rails du circuit. Du fait de leur fonction normale d'amplification de puissance, les transistors 31 et 33 ont des dimensions importantes, et peuvent avantageusement remplacer les éléments de protection des structures classiques du type décrit en relation avec les figures 1 et 2 (transistor 9 et diodes 5 et 7). On notera que pour garantir une protection complète du circuit, on pourra prévoir d'associer une protection adaptée aux plots d'entrée du circuit, par exemple des diodes du type des diodes 5 et 7 de la figure 1, adaptées à reporter sur les rails d'alimentation les surtensions susceptibles de survenir sur les plots d'entrée. Les surtensions pourront alors être évacuées via les étages de sortie des plots de sortie. La figure 6 reprend le schéma de la figure 5, et représente de façon plus détaillée un exemple de réalisation du circuit de commande des transistors de l'étage d'amplification de sortie (circuit 51 de la figure 5).

Comme le circuit 35 décrit en relation avec la figure 4, le circuit de la figure 6 comporte un bloc logique comprenant une porte NON ET 41, une porte NON OU 43, et des inverseurs 45, 46 et 47, pour commander, en fonctionnement normal, les grilles des transistors 31 et 33, en fonction de l'état des signaux d'entrée IN et LOW-Z.

Des résistances 73 et 75, sont ajoutées respectivement entre la sortie de la porte NON ET 41 et la grille du transistor 31 et entre la sortie de la porte NON OU 43 et la grille du transistor 33.

En outre, un circuit de détection et de déclenchement 77 est connecté entre les rails d'alimentation V_{DD} et V_{SS}. Le circuit 77 comporte des sorties CDP et CDN, respectivement connectées aux grilles des transistors 31 et 33.

Un détecteur de fronts, constitué d'une capacité 63 en série avec une résistance 65, est connecté entre les rails V_{DD} et V_{SS}. La porte NON ET 41 est reliée au rail d'alimentation V_{DD} par l'intermédiaire d'un transistor MOS à canal P 61 dont la grille est reliée au noeud A entre la capacité 63 et la résistance 65. La source et le drain du transistor 61 sont respectivement connectés au rail V_{DD} et à la borne d'alimentation haute de la porte NON ET 41. La borne d'alimentation basse de la porte NON ET 41 est connectée au rail V_{SS}.

De même, l'alimentation de la porte NON OU 43 est couplée à un détecteur de fronts, constitué d'une capacité 69 en série avec une résistance 71, connecté entre les rails V_{SS} et V_{DD}. La porte NON OU 43 est reliée au rail d'alimentation V_{SS} par l'intermédiaire d'un transistor MOS à canal N 67 dont la grille est reliée au noeud B entre la capacité 69 et la résistance 71. La source et le drain du transistor 67 sont respectivement connectés au rail V_{SS} et à la borne d'alimentation basse de la porte NON OU 43. La borne d'alimentation haute de la porte NON OU 43 est connectée au rail V_{DD}.

En fonctionnement normal, les signaux CDP et CDN sont à haute impédance et ne perturbent pas le fonctionnement du circuit de commande de l'étage d'amplification. De plus, les noeuds A et B sont à des états respectivement bas et haut, maintenant les transistors 61 et 67 fermés. Ainsi le circuit de commande de l'étage d'amplification est normalement alimenté.

En cas de surtension positive entre les rails V_{DD} et V_{SS}, les signaux CDP et CDN passent respectivement à des états bas et haut. Ainsi, du fait de la présence des résistances 73 et 75, quel que soit l'état de sortie des portes NON ET 41 et NON OU 43, le potentiel sur la grille du transistor MOS à canal P 31 est inférieur au potentiel du rail V_{DD}, et le potentiel sur la grille du transistor MOS à canal N 33 est supérieur au potentiel du rail V_{SS}. Ceci provoque la fermeture simultanée des transistors 31 et 33, et l'évacuation de la surtension.

Le couplage des alimentations des portes NON ET 41 et NON OU 43 à des détecteurs de fronts, est un moyen supplémentaire de garantir la fermeture des transistors 31 et 33, lorsqu'une surtension positive rapide survient entre les rails V_{DD} et V_{SS}, alors que le circuit intégré n'est pas alimenté. Quand le circuit intégré n'est pas alimenté, le noeud A entre la résistance 65 et la capacité 63 est à un état bas. Lorsqu'une surtension rapide survient entre les rails V_{DD} et V_{SS}, le noeud A passe immédiatement à un état haut, c'est à dire sensiblement au même potentiel que le rail V_{DD}, ce qui provoque l'ouverture du transistor 61. Ainsi, malgré la présence d'une tension positive entre les rails V_{DD} et V_{SS}, la porte NON ET 41 n'est pas alimentée, et sa sortie reste flottante, à un état indéterminé. Le signal CDP de sortie du circuit 77 peut donc librement commander la fermeture du transistor 31, pour permettre l'évacuation de la surtension. Un raisonnement sensiblement symétrique s'applique à la porte NON OU 43 et au transistor 33.

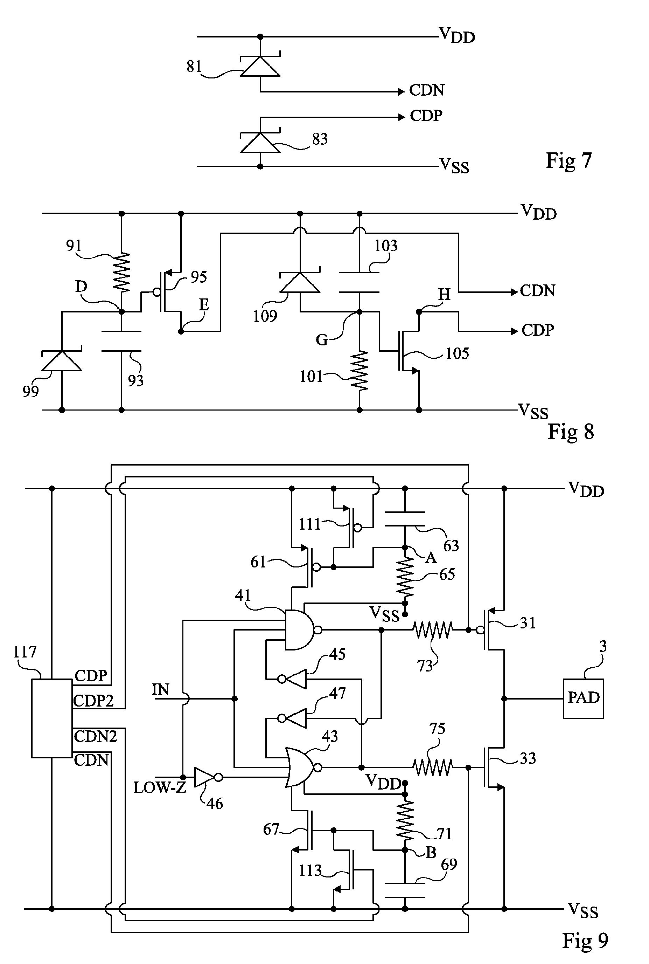

La figure 7 représente un exemple de réalisation du circuit 77 de détection et de déclenchement de la structure de protection de la figure 6. Ce circuit comprend des diodes Zener 81 et 83, connectées respectivement en direct entre la sortie CDN du circuit et le rail V_{DD}, et en inverse entre la sortie CDP du circuit et le rail V_{SS}.

En fonctionnement normal, lorsque le circuit est alimenté, les diodes 81 et 83 sont non passantes, et les sorties CDN et CDP du circuit sont à haute impédance.

Lorsque la différence de potentiel entre les rails V_{DD} et V_{SS} dépasse un certain seuil, les diodes 81 et 83 deviennent passantes en inverse, par effet d'avalanche. Ainsi la sortie CDN passe à un état haut, c'est à dire sensiblement au même potentiel que le rail V_{DD} moins une valeur V_{Z} correspondant à la tension de seuil de la diode 81. En outre, la sortie CDP passe à un état bas, c'est à dire sensiblement au potentiel V_{Z} correspondant à la tension de seuil de la diode 83.

La figure 8 représente une variante de réalisation préférée du circuit 77 de détection et de déclenchement de la structure de protection de la figure 6. Un détecteur de fronts, constitué d'une résistance 91 en série avec une capacité 93, est connecté entre les rails d'alimentation V_{DD} et V_{SS}. Le noeud D entre la résistance 91 et la capacité 93 est connecté à la grille d'un transistor MOS à canal P 95 dont la source est connectée au rail V_{DD} et dont le noeud E de drain est connecté à la sortie CDN du circuit. Une diode Zener 99 est connectée en direct, entre le rail V_{SS} et le noeud D. Un autre détecteur de fronts, constitué d'une résistance 101 en série avec une capacité 103, est connecté entre les rails d'alimentation V_{SS} et V_{DD}. Le noeud G entre la résistance 101 et la capacité 103 est connecté à la grille d'un transistor MOS à canal N 105 dont la source est connectée au rail V_{SS} et dont le noeud de drain H est connecté à la sortie CDP du circuit. Une diode Zener 109 est connectée en inverse entre le rail V_{DD} et le noeud G.

En fonctionnement normal, lorsque le circuit est alimenté, les noeuds D et G sont respectivement à des potentiels haut et bas, et les transistors 95 et 105 sont donc ouverts. Ainsi, les sorties CDN et CDP du circuit sont à haute impédance.

Lorsque la différence de potentiel entre les rails V_{DD} et V_{SS} dépasse un certain seuil, les diodes 99 et 109 deviennent passantes en inverse, par effet d'avalanche. Il s'ensuit une limitation du potentiel du noeud D, et une montée du potentiel du noeud G. Les transistors 95 et 105 deviennent donc passants. Ainsi, les sorties CDN et CDP du circuit passent respectivement à des états haut et bas, c'est à dire sensiblement aux potentiels des rails V_{DD} et V_{SS}.

Lorsque le circuit intégré n'est pas alimenté, les noeuds D et G sont à des états bas. Si une surtension positive rapide survient entre les rails V_{DD} et V_{SS}, le noeud D reste à un état bas, et le noeud G monte rapidement à un état haut, correspondant sensiblement au potentiel du rail V_{DD}. Les transistors 95 et 105 deviennent donc passants et les sorties CDN et CDP du circuit passent respectivement à des états haut et bas.

Un avantage du circuit de détection et de déclenchement de la figure 8 par rapport au circuit de la figure 7 est que dans le circuit de la figure 8, en cas de surtension, les sorties CDP et CDN sont à des potentiels respectivement plus bas et plus haut que dans le cas du circuit de la figure 7. Il en résulte une meilleure conduction des transistors 31 et 33, et donc une meilleure efficacité de la protection.

La figure 9 représente une autre variante de réalisation de la structure de protection de la figure 5. Le circuit de la figure 9 est semblable en de nombreux points au circuit de la figure 6, et les caractéristiques non utiles à la mise en lumière des avantages de ce circuit ne seront pas décrites à nouveau ci-après.

Dans le circuit de la figure 9, le circuit de détection et de déclenchement 77 de la figure 6 est remplacé par un circuit de détection et de déclenchement 117 comprenant, outre les sorties CDP et CDN respectivement connectées aux grilles des transistors 31 et 33, des sorties CDP2 et CDN2.

Comme dans le circuit de la figure 6, la porte NON ET 41 est reliée au rail d'alimentation V_{DD} par l'intermédiaire d'un transistor MOS à canal P 61. Un détecteur de fronts comprenant une capacité 63 en série avec une résistance 65, est connecté entre les rails V_{DD} et V_{SS}. Le noeud entre la capacité 63 et la résistance 65 est connecté à la grille du transistor 61. De même, la porte NON OU 43 est reliée au rail d'alimentation V_{SS} par l'intermédiaire d'un transistor MOS à canal N 67. Un autre détecteur de fronts comprenant une capacité 69 en série avec une résistance 71, est connecté entre les rails V_{SS} et V_{DD}. Le noeud entre la capacité 69 et la résistance 71 est connecté à la grille du transistor 67.

Le circuit de la figure 9 comprend en outre un transistor MOS à canal P 111 dont la source est connectée au rail V_{DD} et dont le drain est connecté à la grille du transistor 61. La grille du transistor 111 est connectée à la sortie CDP2 du circuit de détection et de déclenchement 117. Le circuit de la figure 9 comprend également un transistor MOS à canal N 113 dont la source est connectée au rail V_{SS} et dont le drain est connecté à la grille du transistor 67. La grille du transistor 113 est connectée à la sortie CDN2 du circuit 117.

En fonctionnement normal, les signaux CDP et CDN sont à haute impédance, et les signaux CDP2 et CDN2 sont respectivement à des états haut et bas, maintenant les transistors 111 et 113 ouverts. Les noeuds A et B sont à des états respectivement bas et haut, maintenant les transistors 61 et 67 fermés. Ainsi, le circuit de commande de l'étage d'amplification est alimenté, et, du fait de la haute impédance des sorties CDP et CDN, son fonctionnement normal n'est pas perturbé.

En cas de surtension positive entre les rails V_{DD} et V_{SS}, les signaux CDP et CDN passent respectivement à des états bas et haut, ce qui provoque la fermeture simultanée des transistors 31 et 33, et l'évacuation de la surtension.

Comme dans le circuit de la figure 6, le couplage des alimentations des portes NON ET 41 et NON OU 43 à des détecteurs de fronts, est un moyen supplémentaire de garantir la fermeture des transistors 31 et 33, lorsqu'une surtension positive rapide survient entre les rails V_{DD} et V_{SS}, alors que le circuit intégré n'est pas alimenté.

La prévision des transistors 111 et 113 permet également de garantir la coupure de l'alimentation des portes 41 et 43 lorsqu'une surtension positive lente survient entre les rails V_{DD} et V_{SS}. Lorsqu'une surtension positive survient entre les rails V_{DD} et V_{SS}, les sorties CDP2 et CDN2 du circuit 117 passent respectivement à des états bas et haut, ce qui provoque la fermeture des transistors 111 et 113. Il s'en suit une montée du potentiel de grille du transistor 61 et une chute du potentiel de grille du transistor 67, ce qui provoque l'ouverture des transistors 61 et 67. Les portes NON ET 41 et NON OU 43 ne sont donc pas alimentées et leurs sorties respectives sont flottantes, à des états indéterminés. Le circuit de détection et de déclenchement 117 peut donc librement commander la fermeture des transistors de protection 31 et 33 via ses sorties CDP et CDN.

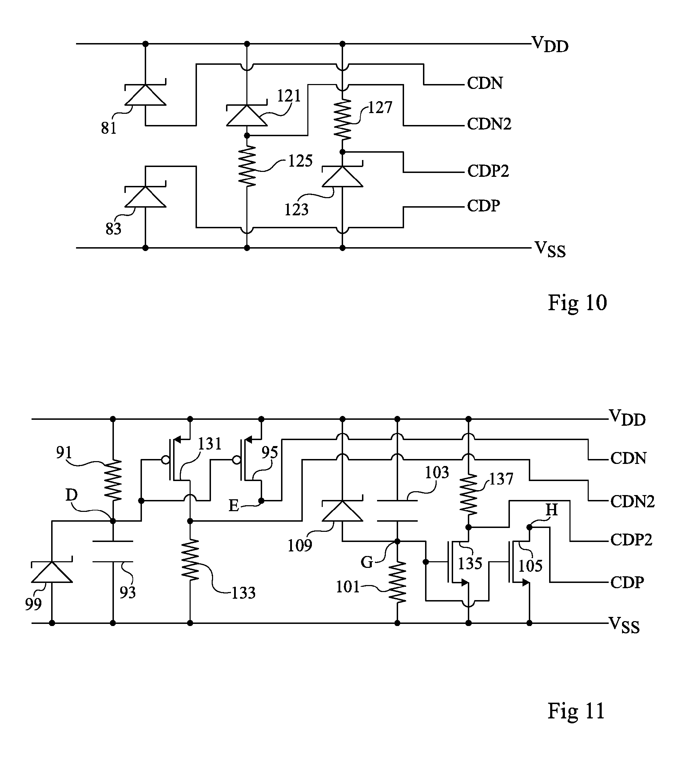

La figure 10 représente un exemple de réalisation du circuit 117 de détection et de déclenchement de la structure de protection de la figure 9. Le circuit de la figure 10 reprend tous les éléments du circuit de la figure 7 et comprend en outre des diodes Zener 121 et 123 connectées respectivement en direct entre la sortie CDN2 et le rail V_{DD}, et en inverse entre la sortie CDP2 du circuit et le rail V_{SS}, ainsi que des résistances 125 et 127 connectées respectivement entre la sortie CDN2 et le rail V_{SS} et entre la sortie CDP2 et le rail V_{DD}.

En fonctionnement normal, lorsque le circuit est alimenté, les diodes 81, 83, 121, et 123 sont non passantes. Ainsi, les sorties CDN et CDP sont à haute impédance et les sorties CDN2 et CDP2 sont respectivement à des états bas et haut.

Lorsque la différence de potentiel entre les rails V_{DD} et V_{SS} dépasse un certain seuil, les diodes 81, 83, 121 et 123 deviennent passantes en inverse, par effet d'avalanche. Ainsi les sorties CDN et CDN2 passent à un état haut, c'est à dire sensiblement au même potentiel que le rail V_{DD} moins une valeur V_{Z} correspondant à la tension de seuil des diodes. En outre, les sorties CDP et CDP2 passent à un état bas, c'est à dire sensiblement au potentiel V_{Z} correspondant à la tension de seuil des diodes.

La figure 11 représente une variante de réalisation préférée du circuit 117 de détection et de déclenchement de la structure de protection de la figure 9. Le circuit de la figure 11 reprend tous les éléments du circuit de la figure 8. Seuls les éléments additionnels seront décrits ici. Le noeud D est connecté à la grille d'un transistor MOS à canal P 131 dont la source est connectée au rail V_{DD} et dont le noeud de drain est connecté à la sortie CDN2 du circuit. Une résistance 133 est connectée entre la sortie CDN2 et le rail V_{SS}. En outre, le noeud G est connecté à la grille d'un transistor MOS à canal N 135 dont la source est connectée au rail V_{SS} et dont le noeud de drain est connecté à la sortie CDP2 du circuit. Une résistance 137 est connectée entre la sortie CDP2 et le rail V_{DD}.

En fonctionnement normal, lorsque le circuit est alimenté, les noeuds D et G sont respectivement à des potentiels haut et bas, maintenant les transistors 95, 131, 105 et 135 ouverts. Ainsi, les sorties CDN et CDP du circuit sont à haute impédance et les sorties CND2 et CDP2 sont respectivement à des états bas et haut.

Lorsque la différence de potentiel entre les rails V_{DD} et V_{SS} dépasse un certain seuil, les diodes 99 et 109 deviennent passantes en inverse, par effet d'avalanche. Il s'ensuit une limitation du potentiel du noeud D, et une montée du potentiel du noeud G. Les transistors 95, 131, 105 et 135 deviennent donc passants. Ainsi, les sorties CDN et CDN2 passent à un état haut, c'est-à-dire sensiblement au potentiel du rail V_{DD}, et les sorties CDP et CDP2 passent à un état bas, c'est à dire sensiblement au potentiels du rail V_{SS}.

Lorsque le circuit intégré n'est pas alimenté, les noeuds D et G sont à des états bas. Si une surtension positive rapide survient entre les rails V_{DD} et V_{SS}, le noeud D reste à un état bas, et le noeud G monte rapidement à un état haut, correspondant sensiblement au potentiel du rail V_{DD}. Les transistors 95, 131, 105 et 135 deviennent donc passants. Les sorties CDN et CDN2 passent à un état haut et les sorties CDP et CDP2 passent à un état bas.

Un avantage des modes de réalisation proposés est qu'ils permettent, dans un circuit intégré, de réduire la surface de silicium spécifiquement dédiée à la protection contre les décharges électrostatiques.

La suppression des transistors MOS spécifiquement dédiés à la protection permet de réduire la surconsommation électrique liée aux courants de fuite à travers ces transistors.

Des modes de réalisation particuliers de la présente invention ont été décrits. Diverses variantes et modifications apparaîtront à l'homme de l'art. En particulier, on a décrit en relation avec les figures 7 et 8, des exemples de réalisation de circuits de détection et de déclenchement. L'invention ne se restreint pas à ces cas particuliers. L'homme de l'art saura utiliser tout autre circuit adapté à détecter des surtensions positives entre les rails V_{DD} et V_{SS} et à commander en conséquence les grilles des transistors de l'étage d'amplification de sortie.

En outre, l'invention ne se restreint pas à l'utilisation du circuit décrit en relation avec la figure 4, pour commander, en fonctionnement normal, l'ouverture et la fermeture des transistors MOS de l'étage d'amplification de sortie.

De même, on pourra prévoir d'autres blocs logiques que ceux décrits en relation avec les figures 6 et 9, pour interrompre, en cas de surtension, l'alimentation du circuit de commande normale des transistors de l'étage d'amplification de sortie.

## Revendications

1. Circuit intégré protégé contre des décharges électrostatiques, dont des plots de sortie (3) sont couplés à des étages d'amplification, chaque étage comprenant, entre des premier (V_{DD}) et second (V_{SS}) rails d'alimentation, un transistor MOS de puissance à canal P (31) en série avec un transistor MOS de puissance à canal N (33), ce circuit intégré comprenant en outre des moyens de protection pour fermer simultanément les deux transistors lorsqu'une surtension positive survient entre les premier et second rails d'alimentation, lesdits moyens de protection comprenant un circuit (77 ; 117) de détection et de déclenchement comprenant :
un premier détecteur de fronts comprenant une résistance (91) en série avec une capacité (93), connecté entre les premier (V_{DD}) et second (V_{SS}) rails ;
un second détecteur de fronts comprenant une résistance (101) en série avec une capacité (103), connecté entre les second (V_{SS}) et premier (V_{DD}) rails ;
un transistor MOS à canal P (95) dont la source et le drain sont respectivement connectés au premier rail (V_{DD}) et à la grille du transistor de puissance à canal N (33), et dont la grille est connectée entre la résistance et la capacité du premier détecteur de fronts ;
un transistor MOS à canal N (105) dont la source et le drain sont respectivement connectés au second rail (V_{SS}) et à la grille du transistor de puissance à canal P (31), et dont la grille est connectée entre la résistance et la capacité du second détecteur de fronts ; et
des première (99) et seconde (109) diodes Zener respectivement connectées en direct entre le second rail (V_{SS}) et la grille du transistor MOS à canal P (95), et entre la grille du transistor MOS à canal N (105) et le premier rail (V_{DD}).

2. Circuit intégré selon la revendication 1, dans lequel dans chaque étage d'amplification, les sources des transistors de puissance à canal P (31) et N (33) sont respectivement reliées aux premier (V_{DD}) et second (V_{SS}) rails d'alimentation, et les drains des transistors de puissance sont reliés au plot de sortie (3).

3. Circuit intégré selon la revendication 1 ou 2, comprenant un circuit de commande (35) de chaque étage d'amplification pour commander, en fonctionnement normal, l'ouverture et la fermeture des transistors de puissance (31, 33), ce circuit de commande comprenant au moins une sortie reliée aux grilles des transistors de puissance, lesdits moyens de protection comprenant des première (73) et seconde (75) résistances respectivement connectées entre ladite au moins une sortie du circuit de commande et les grilles respectives des transistors de puissance à canal P (31) et N (33).

4. Circuit intégré selon la revendication 3, dans lequel le circuit de commande de l'étage d'amplification est relié aux premier (V_{DD}) et second (V_{SS}) rails d'alimentation par l'intermédiaire de transistors MOS à canal P (61) et N (67), dont les grilles respectives sont reliées à des détecteurs de fronts adaptés à commander l'ouverture de ces transistors lorsqu'une surtension positive survient entre les premier et second rails d'alimentation.
